Europäisches Patentamt

European Patent Office

Office européen des brevets

(11) Publication number : **0 564 020 B1**

# EUROPEAN PATENT SPECIFICATION

(45) Date of publication of patent specification :
**21.06.95 Bulletin 95/25**

(51) Int. Cl.[6] : **G03F 7/07,** G03C 8/06,
G03C 1/81, G03C 1/95,
G03C 1/76

(21) Application number : **93200684.4**

(22) Date of filing : **10.03.93**

(54) **A lithographic printing plate according to the silver salt diffusion transfer process.**

(30) Priority : **03.04.92 EP 92200949**

(43) Date of publication of application :
**06.10.93 Bulletin 93/40**

(45) Publication of the grant of the patent :
**21.06.95 Bulletin 95/25**

(84) Designated Contracting States :
**BE DE FR GB NL**

(56) References cited :
**EP-A- 0 253 534**
**EP-A- 0 474 922**
**DATABASE WPIL Section Ch, Week 8949, Derwent Publications Ltd., London, GB; Class A89, AN 89-361229**
**PATENT ABSTRACTS OF JAPAN vol. 14, no. 35 (P-994)23 January 1990**
**PATENT ABSTRACTS OF JAPAN vol. 10, no. 41 (P-429)(2098) 18 February 1986**
**PATENT ABSTRACTS OF JAPAN vol. 12, no. 188 (P-711)(3035) 2 June 1988**

(73) Proprietor : **AGFA-GEVAERT naamloze vennootschap**
**Septestraat 27**
**B-2640 Mortsel (BE)**

(72) Inventor : **Claeys, Daniel**
**c/o Agfa-Gevaert N.V.,**
**DIE 3800,**
**Septestraat 27**
**B-2640 Mortsel (BE)**
Inventor : **Vaes, Jos**
**c/o Agfa-Gevaert N.V.,**
**DIE 3800,**
**Septestraat 27**
**B-2640 Mortsel (BE)**
Inventor : **Van Gorp, Herman**
**c/o Agfa-Gevaert N.V.,**
**DIE 3800,**
**Septestraat 27**
**B-2640 Mortsel (BE)**

## Description

### 1. Field of the invention.

The present invention relates to lithographic printing plates having a paper support and that are obtained by the silver salt diffusion transfer process.

### 2. Background of the invention.

The principles of the silver complex diffusion transfer reversal process, hereinafter called DTR-process, have been described e.g. in US-P- 2352014 and the book "Photographic Silver Halide Diffusion Processes" by André Rott and Edith Weyde - The Focal Press -London and New York, (1972).

According to the DTR process, a silver complex salt is image-wise transferred by diffusion from the image-wise exposed silver halide emulsion layer into the image receiving layer, where it is converted to a silver image usually in the presence of physical development nuclei. For this purpose, the image-wise exposed silver halide emulsion layer is developed in the presence of a developing agent and non-developed silver halide is converted by means of a silver halide complexing agent into a soluble silver complex salt while in contact with an image receiving layer.

A DTR-image bearing material can be used as a planographic printing plate wherein the DTR-silver image areas form the water-repellant ink-receptive areas on a water-receptive ink-repellant surface. The DTR-image can be formed in the image-receiving layer of a sheet or web material which is a separate element with respect to the photographic silver halide emulsion material (a so-called two-sheet DTR element) disclosed in e.g. DE-A-2.346.378 or in the image-receiving layer of a so-called single-support-element, also called mono-sheet element, which contains at least one photographic silver halide emulsion layer integral with an image-receiving layer in water permeable relationship therewith. It is the latter mono-sheet version which is preferred for the preparation of offset printing plates by the DTR method. Supports that are commonly used with these type of printing plates are paper and polyester film supports.

Typically a mono-sheet DTR material comprises on one side of the support a silver halide emulsion layer and a surface layer of physical development nuclei and on the side of the support opposite to the side of the support containing the silver halide emulsion layer one or more backing layers. These backing layers are required to avoid curling of the DTR material in its production. Curling of a photographic material is well known and is due to forces that act on the support during drying of the layers applied thereto. By providing one or more backing layers on the non-photosensitive side of the DTR material the forces will act on both sides of the support and can be tuned to balance each other thus avoiding curl.

The backing layer(s) of a mono-sheet DTR material also contain(s) a matting agent to ensure smooth transport of the DTR material in automatic cameras, to avoid sticking of plates to each other in a package, to avoid damaging of one plate by the back of another in a package etc.

Because backing layers of a mono-sheet DTR material contain a substantial amount of hydrophilic colloid they have the disadvantage of absorbing a certain amount of processing liquid so that the processing liquid is more rapidly exhausted than in case the DTR material comprises no backing layers. Furthermore the time needed for drying the plate is increased.

On the other hand, when decreasing the total amount of hydrophilic colloid on the back side of a paper support of a mono-sheet DTR material having provided on said back side a matting agent, a lithographic printing plate prepared therefrom starts tearing at the edges where the plate is mounted on the printing press during printing. As a consequence thereof the image printed will shift during the printing process which is undesirable when two or more images are printed on top of each other.

EP-A-474922 discloses a monosheet DTR imaging element for making a printing plate comprising a polyester support provided with a backing layer containing matting agent and 4.3g/m$^2$ of gelatin. EP-A-253534 discloses a photographic material having a paper base and containing a backing layer having 2g/m$^2$ of gelatin. JP-A-60-188942 discloses that by adding matting agent to the backing layer of a photographic material, the traveling performance of an automatic conveyor is improved. JP-A-01-271752 discloses that by adding colloidal fine particles to the outermost backing layer of a DTR imaging element for plate making, the conveying properties of the plate are improved.

### 3. Summary of the invention.

It is an object of the present invention to provide a method for making a paper based lithographic printing plate according to the DTR process not having the disadvantages mentioned above.

It is a further object of the present invention to provide a mono-sheet DTR material for use in said method. Further objects of the present invention will become clear from the description hereinafter.

According to the present invention there is provided a mono-sheet DTR material comprising on one side of a paper support forming the photosensitive side of said monosheet DTR material a photosensitive layer containing a silver halide emulsion and an image receiving layer containing physical development nuclei and on the side of the support opposite to said photosensitive side one or more backing layers comprising hydrophilic colloid characterized in that the amount of hydrophilic colloid in said backing layer(s) less than $4g/m^2$ and in that the backing layer(s) :

- is (are) free from matting agent, or
- contain(s) an organic matting agent, or
- contain(s) an inorganic matting agent provided the amount of inorganic matting agent particles having a diameter larger than the thickness of said backing layer(s) is not more than 0.2 $g/m^2$.

According to the present invention there is also provided a method for making a lithographic printing plate according to the DTR process using the above defined mono-sheet DTR material.

4. Detailed description of the invention.

According to the present invention it has been found that the problem of tearing during printing of a lithographic printing plate prepared from a paper based mono-sheet DTR material containing one or more backing layers containing a total amount of hydrophilic colloid not more than $4g/m^2$ at the edges where the plate is mounted to the printing press is caused by the type and amount of matting agent used. Thus when the matting agent used in said backing layer(s) according to the invention is an organic matting agent the problem of tearing does not occur. However inorganic matting agents may also be used provided that the total amount thereof having a diameter larger than the thickness of said backing layer(s) (hereinafter referred to as protruding matting agent) is 0.2$g/m^2$ or less and more preferably not more than 0.15$g/m^2$.

The amount of protruding inorganic matting agent not more than 0.2$g/m^2$ may be obtained in various ways. For example a homodisperse inorganic matting agent having an average diameter equal to or less than the total thickness of the backing layers can be used. Alternatively a heterodisperse inorganic matting agent can be used. In this case the total amount of the heterodisperse inorganic matting agent is adjusted such that the fraction thereof having a diameter larger than the total thickness of the backing layers is 0.2$g/m^2$ or less. Furthermore when matting agents are completely omitted from the backing layers the problem of tearing is also avoided. However the use of a matting agent is preferred to avoid e.g. transport problems in automatic cameras.

Examples of inorganic matting agents that can be used in accordance with the present invention are e.g. $SiO_2$, $TiO_2$, $Al_2O_3$ etc.. Examples of organic matting agents are e.g. polymethyl methacrylate, polymethyl acrylate, polyethylene etc.. A further interesting type of matting agents that can be used in connection with the present invention are alkali soluble matting agents. These type of matting agents offer the advantage that they do not melt or dissolve during preparation and storage of the monosheet DTR-material and dissolve in the alkaline processing solution during development of the DTR-material so that the matting agent will be present when needed i.e. during storage but will be removed during processing of the DTR-material and as a consequence thereof cannot interfere anymore during printing. Examples of such type of matting agents are e.g. copolymers of (meth)acrylates and (meth)acrylic acid such as e.g. a copolymer of methyl and/or ethyl methacrylate and methacrylic acid in a molar ratio of methacrylate to methacrylic acid between 5:5 and 9:1, copolymers of methyl methacrylate, stearyl methacrylate and (meth)arcylic acid etc.. The average diameter of the matting agent used in accordance with the present invention is preferably between 1$\mu$m and 8$\mu$m and more preferably between 1$\mu$m and 5$\mu$m.

The hydrophilic colloid used in the backing layer(s) in accordance with the present invention is preferably gelatin but instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.. A preferably used hydrophilic colloid is gelatin. The gelatin used in the backing layer(s) according to the invention is preferably low isoelectric point gelatin i.e. having an isoelectric point between 4 and 5 however high isoelectric point gelatin having an isoelectric point between 7.5 and 9 can also be used. The backing layers according to the invention are preferably hardened. They can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen com-

EP 0 564 020 B1

pounds e.g. 2,4-dichloro-6-hydroxy-s-triazine, and mucohalogenic acids e.g. mucochloric acid and mucophenoxychloric acid. These hardeners can be used alone or in combination. Hardening may also be carried out with fast-reacting hardeners such as carbamoylpyridinium salts of the type, described in US 4,063,952.

According to the present invention part the backing layer(s) preferably contain a fine inorganic particle having an average diameter not more than 1μm preferably between 5nm and 500nm so that the total amount of hydrophilic colloid in the backing layer(s) can be substantially reduced below $4g/m^2$ without imparting the layer strength. Examples of fine inorganic particles are e.g. colloidal silica or $TiO_2$. The amount of said fine inorganic particles in the backing layer(s) according to the invention is preferably between $0.1g/m^2$ and $1.4g/m^2$ and more preferably between $0.4g/m^2$ and $1g/m^2$. Preferably however the total amount of hydrophilic colloid in the backing layer(s) will be at least $0.5g/m^2$. Preferably the amount of hydrophilic colloid is between $0.5g/m^2$ and $3g/m^2$.

According to the present invention the backing layers may comprise additional ingredients e.g. antistatic agents, wetting agents, anti-halo substances etc.

According to the method of the present invention for obtaining a lithographic printing plate a DTR mono-sheet material comprising on one side of a paper support forming the photosensitive side of the DTR material in the order given a silver halide emulsion layer and an image receiving layer containing physical development nuclei and on the side opposite to the photosensitive side one or more backing layers according to the invention is image-wise exposed and subsequently developed in an alkaline processing liquid in the presence of developing agent(s) and silver halide solvent(s).

The DTR mono-sheet imaging element according to the present invention is exposed in an apparatus according to its particular application, e.g. a conventional process camera containing a conventional light source or a laser containing device. Examples of HeNe laser containing exposure units are the image-setters LINOTRONIC 300, marketed by LINOTYPE Co, and CG 9600, marketed by AGFA COMPUGRAPHIC. An image-setter provided with an Ar ion laser is LS 210, marketed by Dr-Ing RUDOLF HELL GmbH. Exposure units provided with a laserdiode are LINOTRONIC 200, marketed by LINOTYPE Co, and CG 9400, marketed by AGFA COMPUGRAPHIC.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used. Said developing agents may be contained in an alkaline processing liquid but are preferably contained in one or more layers of the mono-sheet DTR material. In the latter case the alkaline processing liquid merely serves as an alkaline activating liquid.

The pH of said activating liquid is preferably between 12 and 14 and may be established by an organic and/or inorganic alkali agent. Examples of suitable alkali agents are e.g. sodium hydroxide, carbonates, secundary and/or tertiary alkanolamines, amines etc. or mixtures thereof.

It is furthermore essential that the DTR-process is carried out in the presence of (a) silver halide solvent(s). Said silver halide solvent(s) can be present in one or more layers comprised in the mono-sheet DTR material but are preferably comprised in the alkaline processing liquid. Suitable silver halide solvents for use in accordance with the present invention are e.g. thiosulphate or thiocyanate. Further interesting silver halide complexing agents, are cyclic imides, preferably combined with alkanolamines, as described in US-P 4,297,430 and US-P 4,355,090 and 2-mercaptobenzoic acid derivatives as described in US-P 4,297,429, preferably combined with alkanolamines or with cyclic imides and alkanolamines.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

The alkaline processing liquid can contain one or more hydrophobizing agents to enhance the ink-receptive properties of the DTR silver image, e.g. those described in US-P 3,776,728, and US-P 4,563,410. Preferred compounds are 5-n-heptyl-2-mercapto-1,3,4,-oxadiazol and 3-mercapto-4-acetamido-5-n.heptyl-1,2,4-triazole.

Development acceleration can be accomplished with the aid of various compounds to the alkaline processing liquid and/or one or more layers of the mono-sheet DTR material, preferably polyalkylene derivatives having a molecular weight of at least 400 such as those described in e.g. US-P 3,038,805 - 4,038,075 - 4,292,400 - 4,975,354.

According to the method of the present invention an image-wise exposed monosheet-DTR imaging ele-

4

ment is processed in an alkaline processing solution having a composition as described above. The development and diffusion transfer can be initiated in different ways e.g. by rubbing with a roller that has been wetted with the processing liquid, e.g. acts as meniscus coater, by wiping with an absorbent means e.g. with a plug of cotton or sponge, or by dipping the material to be treated in the liquid composition. Preferably, they proceed in an automatically operated apparatus such as PAPILINE SP 430, marketed by AGFA or so called "camera plate makers" as SP100 or SP400 marketed by AGFA. The DTR-process is normally carried out at a temperature in the range of 10°C to 35°C. In order to minimize the quality loss due to bath exhaustion, regenerating liquids can be added in proportion to the consumption of processing liquids. Preferably the DTR material is subsequently guided through a neutralization solution. In order to reduce the pH of the wet swollen DTR element leaving the alkaline processing solution, the neutralization liquid contains buffer ions, e.g. phosphate buffer or citrate buffer to establish in said liquid a pH value ranging from 5.0 to 7.0. The neutralization solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Finally the neutralization solution can contain wetting agents, preferably compouds containing perfluorinated alkyl groups.

The photographic silver halide emulsion suitable for use in accordance with the invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

According to the present invention the emulsion or emulsions preferably consist principally of silver chloride while a fraction of silver bromide is present ranging from 1 mole % to 40 mole %. The emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

The average size of the silver halide grains may range from 0.10 to 0.70 $\mu$m , preferably from 0.25 to 0.45 $\mu$m.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

Preferably during the precipitation stage Iridium and/or Rhodium containing compounds or a mixture of both are added. The concentration of these added compounds ranges from $10^{-8}$ to $10^{-3}$ mole per mole of $AgNO_3$, preferably between $10^{-7}$ and $10^{-6}$ mole per mole of $AgNO_3$. This results in the building in in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

The silver halide emulsions may contain the usual stabilizers e.g. homopolar or salt-like compounds of mercury with aromatic or heterocyclic rings such as mercaptotriazoles; simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

In an especially preferred embodiment the emulsion layer contained in the mono-sheet DTR material contains a compound which comprises in its molecular structure a group capable of adsorbing to silver halide and a group capable of reducing silver halide. Compounds of this kind have been disclosed in the European Patent Application No 449340. In this way a combination of a stabilizing and a development activating function in one compound is achieved.

More details about the composition, preparation and coating of silver halide emulsions can be found in e.g. Product Licensing Index, Vol. 92, December 1971, publication 9232, p. 107-109.

The layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

In addition to the above described emulsion layer and layer containing physical development nuclei other hydrophilic colloid layers in water permeable relationship with these layers may be present. For example additional silver halide emulsion layers may be present as disclosed in US-P-4,772,535, an intermediate hydrophilic colloid layer may be provided between the photosensitive silver halide emulsion layer and the surface layer containing physical development nuclei, etc.. It is especially advantageous to include a base-layer between the support and the photosensitive silver halide emulsion layer. In a preferred embodiment of the present invention said base-layer serves as an antihalation layer. This layer can therefore contain the same light-absorbing dyes as described above for the emulsion layer ; as alternative finely divided carbon black can be used for the same antihalation purposes as described in US-P 2,327,828. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

The hydrophilic layers on the photosensitive side of the support usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. Other hydrophilic colloid binders suitable for use in the hydrophilic layers on the photosensitve side are e.g. those mentioned for use in the backing layer(s).

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the mono-sheet DTR material or the hardening of one layer may be adjusted by the diffusion of a hardener from another layer.

The hardening level of the layer package on the photosensitive side of the mono-sheet DTR material that will also form the printing side is an important factor in controlling the printing endurance of the lithographic printing plate obtained from such a mono-sheet DTR material. When the hardening level is too low the printing endurance will also be low while a too high hardening level will also yield low printing endurances since this will object the diffusion of the silver halide complexed by the silver solvent to the image receiving layer of physical development nuclei so that the strength of the silver image on the surface will be small.

The hardening level of a gelatine layer package on the photosensitive side of the mono-sheet DTR material can be determined using enzymatic hydrolysis of the gelatine. The procedure is as follows.

The photosensitive side of the mono-sheet DTR material is swollen in a buffer solution at pH=7. After 5min. an aqueous solution of 2% of protease 660L (commercially avalaible from Solvay) is applied to the swollen layers and the decrease of the thickness of the layers is measured with time. The procedure is carried out at 49°C. Since the enzymatic hydrolysis is directly related to the hardening level the hardening level can be expressed as the rate of hydrolysis under the above described conditions. The hardening level of the layer package on the photosensitive side of the mono-sheet DTR material according to the present invention is preferably between $0.4*10^{-2}\mu m/s$ and $1.5*10^{-2}\mu m/s$ expressed as the rate of decrease of the layer thickness under enzymatic hydrolysis.

The mono-sheet DTR material used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The mono-sheet DTR material of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

The present invention will now be illustrated by the following example without however limiting it thereto. All parts are by weight unless otherwise specified.

EXAMPLE

7 DTR monosheet materials were prepared as follows. One side of a paper support was coated with an antihalation layer and an emulsion layer and the other side was coated with a backing layer at dry thickness of 3μm. The backing layer contained 2.6g/m² of gelatin. Further details of the different monosheet materials are given in table 1. After drying these layers were subjected to a temperature of 40 °C for 5 days and then the emulsion layer was overcoated with a layer containing development nuclei.

The antihalation layer contained 0.1 g/m² of carbon black, 3 g/m² of gelatin and 0.8 g/m² of silica particles of 4 micron average diameter.

The emulsion was a typical chlorobromide emulsion composed of 98.2 mol % of chloride and 1.8 mol % of bromide, having an average grain size of 0.36 micron and containing Rhodium ions as internal dopant. The emulsion was orthochromatically sensitized.

The emulsion layer contained 1.5 g/m² of silver halide expressed as $AgNO_3$, 1.5 g/m² of gelatin, 0.15 g/m² of 1-phenyl-4,4′-dimethyl-3-pyrazolidinone and 0.25 g/m² of hydroquinone.

Table 1

| no. | matting agent | | | protruding amount |
| --- | --- | --- | --- | --- |
| | type | d($\mu$m) | amount (g/m$^2$) | (g/m$^2$) |
| 1 | SiO$_2$ | 3.7 | 1.3 | 0.65 |
| 2 | SiO$_2$ | 3.7 | 0.4 | 0.2 |
| 3 | SiO$_2$ | 3.7 | 0.1 | 0.05 |
| 4 | PMMA | 6.2 | 0.85 | 0.82 |
| 5 | PMMA | 6.2 | 0.1 | 0.095 |
| 6 | PMMA | 3.0 | 0.85 | 0.43 |
| 7 | PMMA | 3.0 | 0.1 | 0.05 |

In the above table d represents the average diameter of the matting agent, PMMA represents polymethyl methacrylate and the protruding amount represents the amount of the matting agent that has a diameter larger than the thickness of the backing layer.

The thus prepared DTR-material was image-wise exposed and processed with an activator solution having the composition shown below and subsequently neutralized at 25 °C with the neutralization solution also shown below.

Activator solution:

| | |
| --- | --- |
| sodium hydroxide (g) | 30 |
| sodium sulphite anh. (g) | 33 |
| potassium thiocyanate (g) | 20 |
| 3-mercapto-4-acetamido-5-n.heptyl-1,2,4-triazole (g) | 0.15 |
| water to make | 1 l |

Neutralization solution:

| | |
| --- | --- |
| citric acid | 10 g |
| sodium citrate | 35 g |
| cysteine | 1 g· |
| sodium sulphite anh. | 5 g |
| phenol | 50 mg |
| water to make | 1 l |

The thus obtained lithographic printing plates were mounted on an ABD 9860 offset press (commercially available from AB-Dick) by means of the perforations in the plate. Upto about 5000 copies were printed using a commonly used ink and dampening liquid and the tearing of the paper plate at the perforations was visually evaluated and a number from 1 to 4 was assigned to the result. A large number indicates a high level of tearing (4 indicates a complete tearing of the plate at the mounting places of the plate).

EP 0 564 020 B1

```
                              Table 2 (results)
          no.                tearing level
           1                       4
           2                       3
           3                       1
           4                       1
           5                       1
           6                       1
           7                       1
```

## Claims

1. A mono-sheet DTR material comprising on one side of a paper support forming the photosensitive side of said mono-sheet DTR material a photosensitive layer containing a silver halide emulsion and an image receiving layer containing physical development nuclei and on the side of the support opposite to said photosensitive side one or more backing layers comprising hydrophilic colloid characterized in that the total amount of hydrophilic colloid in said backing layer(s) is less than $4g/m^2$ and in that the backing layer(s) :
   - is (are) free from matting agent, or
   - contain(s) an organic matting agent, or
   - contain(s) an inorganic matting agent provided the amount of inorganic matting agent particles having a diameter larger than the thickness of said backing layer(s) is not more than $0.2 \, g/m^2$.

2. A monosheet DTR material according to claim 1 wherein said amount of inorganic matting agent particles having a diameter larger than the thickness of said backing layer(s) is not more than $0.15g/m^2$.

3. A monosheet DTR material according to claim 1 wherein said matting agent is an alkali soluble matting agent.

4. A monosheet DTR material according to any of the preceding claims wherein the average diameter of said matting agent is between $1\mu m$ and $8\mu m$.

5. A monosheet DTR material according to any of the preceding claims wherein said backing layer further comprises fine inorganic particles having an average diameter between 5nm and 500nm.

6. A method for obtaining a lithographic printing plate comprising the steps of:
   - image-wise exposing a monosheet DTR material comprising on one side of a paper support forming the photosensitive side of said mono-sheet DTR material a photosensitive layer containing a silver halide emulsion and an image receiving layer containing physical development nuclei and on the side of the support opposite to said photosensitive side one or more backing layers comprising hydrophilic colloid and
   - developing the thus obtained image-wise exposed monosheet DTR material in the presence of developing agent(s) and silver halide solvent(s) characterized in that the total amount of hydrophilic colloid in said backing layer(s) is less than $4g/m^2$ and in that the backing layer(s) :
   - is (are) free from matting agent, or
   - contain(s) an organic matting agent, or
   - contain(s) an inorganic matting agent provided the amount of inorganic matting agent particles having a diameter larger than the thickness of said backing layer(s) is not more than $0.2 \, g/m^2$.

7. A method according to claim 6 wherein said -amount of inorganic matting agent particles having a diameter larger than the total thickness of said backing layer(s) is not more than $0.15g/m^2$.

8. A method according to claim 6 wherein said matting agent is an organic matting agent.

9

9. A method according to claim 6 wherein said matting agent is an alkali soluble matting agent.

10. A method according to any of the claims 6 to 9 wherein the average diameter of said matting agent is between 1μm and 8μm.

11. A method according to any claims 6 to 10 wherein said backing layer(s) further comprise(s) a fine inorganic particle having an average diameter between 5nm and 500nm.


**Patentansprüche**

1. Ein Einblattmaterial für die Diffusionsübertragungs-Umkehrverarbeitung (=DTR), das auf der einen Seite eines Papierträgers, die die fotoempfindliche Seite dieses DTR-Einblattmaterials bildet, eine eine Silberhalogenidemulsion enthaltende, fotoempfindliche Schicht und eine physikalische Entwicklungskeime enthaltende Bildempfangsschicht, und auf der anderen Seite des Trägers, und zwar der Gegenseite dieser fotoempfindlichen Seite, eine oder mehrere hydrophiles Kolloid enthaltende Rückschichten umfaßt, dadurch gekennzeichnet, daß die Gesamtmenge hydrophiles Kolloid in der Rückschicht bzw. in den Rückschichten weniger als 4 g/m² beträgt und diese Rückschicht bzw. diese Rückschichten :
   - mattiermittelfrei ist bzw. sind, oder
   - ein organisches Mattiermittel enthält bzw. enthalten, oder
   - ein anorganisches Mattiermittel enthält bzw. enthalten unter der Bedingung, daß die Menge der anorganischen Mattiermittelteilchen, deren Durchmesser größer ist als die Stärke dieser Rückschicht bzw. dieser Rückschichten, nicht mehr als 0,2 g/m² beträgt.

2. Ein DTR-Einblattmaterial nach Anspruch 1, dadurch gekennzeichnet, daß diese Menge der anorganischen Mattiermittelteilchen, deren Durchmesser größer ist als die Stärke dieser Rückschicht bzw. dieser Rückschichten, nicht mehr als 0,15 g/m² beträgt.

3. Ein DTR-Einblattmaterial nach Anspruch 1, dadurch gekennzeichnet, daß dieses Mattiermittel ein alkalilösliches Mattiermittel ist.

4. Ein DTR-Einblattmaterial nach irgendeinem der vorstehenden Ansprüche. dadurch gekennzeichnet, daß der durchschnittliche Durchmesser dieses Mattiermittels im Bereich von 1 bis 8 μm liegt.

5. Ein DTR-Einblattmaterial nach irgendeinem der vorstehenden Ansprüche, dadurch-gekennzeichnet, daß diese Rückschicht weiterhin feine, anorganische Teilchen mit einem durchschnittlichen Durchmesser im Bereich von 5 bis 500 nm enthält.

6. Ein Fertigungsverfahren für eine lithografische Druckplatte, das die folgenden Schritte umfaßt :
   - das bildmäßige Belichten eines DTR-Einblattmaterials, das auf der einen Seite eines Papierträgers, die die fotoempfindliche Seite dieses DTR-Einblattmaterials bildet, eine eine Silberhalogenidemulsion enthaltende, fotoempfindliche Schicht und eine physikalische Entwicklungskeime enthaltende Bildempfangsschicht, und auf der anderen Seite des Trägers, und zwar der Gegenseite dieser fotoempfindlichen Seite, eine oder mehrere hydrophiles Kolloid enthaltende Rückschichten umfaßt, und
   - das Entwickeln des so erhaltenen, bildmäßig belichteten DTR-Einblattmaterials in der Gegenwart einer oder mehrerer Entwicklersubstanzen und eines oder mehrerer Silberhalogenid-Lösungsmittel, dadurch gekennzeichnet, daß die Gesamtmenge hydrophiles Kolloid in der Rückschicht bzw. in den Rückschichten weniger als 4 g/m² beträgt und diese Rückschicht bzw. diese Rückschichten :
   - mattiermittelfrei ist bzw. sind, oder
   - ein organisches Mattiermittel enthält bzw. enthalten, oder
   - ein anorganisches Mattiermittel enthält bzw. enthalten unter der Bedingung, daß die Menge der anorganischen Mattiermittelteilchen, deren Durchmesser größer ist als die Stärke dieser Rückschicht bzw. dieser Rückschichten, nicht mehr als 0,2 g/m² beträgt.

7. Ein Verfahren nach Anspruch 6, dadurch gekennzeichnet, daß diese Menge der anorganischen Mattiermittelteilchen, deren Durchmesser größer ist als die Gesamtstärke dieser Rückschicht bzw. dieser Rückschichten, nicht mehr als 0,15 g/m² beträgt.

8. Ein Verfahren nach Anspruch 6, dadurch gekennzeichnet, daß dieses Mattiermittel ein organisches Mattiermittel ist.

9. Ein Verfahren nach Anspruch 6, dadurch gekennzeichnet, daß dieses Mattiermittel ein alkalilösliches Mattiermittel ist.

10. Ein Verfahren nach irgendeinem der Ansprüche 6 bis 9, dadurch gekennzeichnet, daß der durchschnittliche Durchmesser dieses Mattiermittels im Bereich von 1 bis 8 μm liegt.

11. Ein Verfahren nach irgendeinem der Ansprüche 6 bis 10, dadurch gekennzeichnet, daß diese Rückschicht bzw. diese Rückschichten weiterhin ein feines. anorganisches Teilchen mit einem durchschnittlichen Durchmesser im Bereich von 5 bis 500 nm enthält bzw. enthalten.

**Revendications**

1. Un matériau à feuille unique pour le traitement d'inversion par diffusion-transfert (=DTR) comportant sur un côté d'un support en papier constituant le côté photosensible de ce matériau DTR à feuille unique une couche photosensible renfermant une émulsion à l'halogénure d'argent et une couche réceptrice d'image renfermant des germes de développement physique, et sur l'autre côté du support, opposé à ce côté photosensible, une ou plusieurs couches dorsales renfermant un colloïde hydrophile, caractérisé en ce que la quantité totale du colloïde hydrophile dans la ou les couche(s) dorsale(s) s'élève à moins de 4 g/m$^2$ et cette ou ces couche(s) dorsale(s) :
   - est ou sont exempte(s) d'agent de mattage, ou
   - contient ou contiennent un agent de matage organique, ou
   - contient ou contiennent un agent de matage inorganique, pourvu que la quantité des particules d'agent de matage inorganique dont le diamètre est plus grand que l'épaisseur de cette ou ces couche(s) dorsale(s) ne soit pas supérieure à 0,2 g/m$^2$.

2. Un matériau DTR à feuille unique suivant la revendication 1, caractérisé en ce que cette quantité des particules d'agent de matage inorganique dont le diamètre est plus grand que l'épaisseur de cette ou ces couche(s) dorsale(s) n'est pas supérieure à 0,15 g/m$^2$.

3. Un matériau DTR à feuille unique suivant la revendication 1, caractérisé en ce que cet agent de matage est un agent de matage soluble en liquide alcalin.

4. Un matériau DTR à feuille unique suivant l'une quelconque des revendications précédentes, caractérisé en ce que le diamètre moyen de cet agent de matage est compris entre 1 et 8 μm.

5. Un matériau DTR à feuille unique suivant l'une quelconque des revendications précédentes, caractérisé en ce que cette couche dorsale renferme en plus des particules inorganiques, fines au diamètre moyen compris entre 5 et 500 nm.

6. Un procédé pour la confection d'une plaque d'impression lithographique comportant les opérations suivantes :
   - l'exposition suivant une image d'un matériau DTR à feuille unique comportant sur un côté d'un support en papier constituant le côté photosensible de ce matériau DTR à feuille unique une couche photosensible renfermant une émulsion à l'halogénure d'argent et une couche réceptrice d'image renfermant des germes de développement physique, et sur l'autre côté du support, opposé à ce côté photosensible, une ou plusieurs couches dorsales renfermant un colloïde hydrophile, et
   - le développement du matériau DTR à feuille unique, exposé suivant une image, ainsi obtenu, dans la présence d'un ou plusieurs développateurs et d'un ou plusieurs solvants de l'halogénure d'argent. caractérisé en ce que la quantité totale du colloïde hydrophile dans la ou les couche(s) dorsale(s) s'élève à moins de 4 g/m$^2$ et cette ou ces couche(s) dorsale(s) :
   - est ou sont exempte(s) d'agent de mattage, ou
   - contient ou contiennent un agent de matage organique, ou
   - contient ou contiennent un agent de matage inorganique, pourvu que la quantité des particules d'agent de matage inorganique dont le diamètre est plus grand que l'épaisseur de cette ou ces couche(s) dorsale(s) ne soit pas supérieure à 0,2 g/m$^2$.

7. Un procédé suivant la revendication 6, caractérisé en ce que cette quantité des particules d'agent de matage inorganique dont le diamètre est plus grand que l'épaisseur totale de cette ou ces couche(s) dorsale(s) n'est pas supérieure à 0,15 g/m².

8. Un procédé suivant la revendication 6, caractérisé en ce que cet agent de matage est un agent de matage organique.

9. Un procédé suivant la revendication 6, caractérisé en ce que cet agent de matage est un agent de matage soluble en liquide alcalin.

10. Un procédé suivant l'une quelconque des revendications 6 à 9, caractérisé en ce que le diamètre moyen ce cet agent de matage est compris entre 1 et 8 μm.

11. Un procédé suivant l'une quelconque des revendications 6 à 10, caractérisé en ce que cette ou ces couche(s) dorsale(s) renferme(nt) en plus une particule inorganique, fine au diamètre moyen compris entre 5 et 500 nm.